Europäisches Patentamt

European Patent Office

Office européen des brevets

(11) Publication number: **0 162 703**
**A2**

# EUROPEAN PATENT APPLICATION

(21) Application number: **85303586.3**

(22) Date of filing: **21.05.85**

(51) Int. Cl.⁴: **H 05 K 13/00**
**H 05 K 13/02**

(30) Priority: **23.05.84 US 613108**

(43) Date of publication of application:
**27.11.85 Bulletin 85/48**

(84) Designated Contracting States:
**AT BE CH DE FR GB IT LI NL SE**

(71) Applicant: **MACHINE TECHNOLOGY INC.**
**20 Leslie Court**
**Whippany New Jersey 07981(US)**

(72) Inventor: **Hillman, Gary**
**15 Goodhart Drive**
**Livingston N.J. 07039(US)**

(72) Inventor: **Rubin, Richard Howard**
**159 C Meriline Ave**
**West Paterson N.J. 07424(US)**

(72) Inventor: **Heim, Richard Courtland**
**505 Preston Ave**
**Mountainview, Cal. 94040(US)**

(72) Inventor: **Devico, Michael**

**deceased(US)**

(74) Representative: **Beresford, Keith Denis Lewis et al,**
**R.G.C. Jenkins & Co. 12-15, Fetter Lane**
**London EC4A 1PL(GB)**

(54) Modular processing apparatus and modules for use therewith.

(57) A modular processing apparatus includes a chassis adapted to removably receive a plurality of individual modules, each of which performs a specific process function on a workpiece, such as a silicon wafer. A load module includes a flexible arm adapted to be extended and retracted so as to move the workpiece between at least two locations. The flexible arm is provided with a vacuum tube for applying suction to the workpiece in order to maintain the workpiece on the arm during the extension and retraction of the arm. An elevator module moves a workpiece cassette up and down, the elevator module being constructed with minimal moving parts so as to inhibit contamination of the workpieces in the cassette.

./...

FIG. 1

# MODULAR PROCESSING APPARATUS AND MODULES FOR USE THEREWITH

The present invention relates to a modular processing apparatus, and, more particularly, to such an apparatus which is especially adapted for use in connection with the manufacture of semiconductor devices from silicon wafers.

A key to profits in many fabrication processes is factory automation: removing people from the fabrication area for a host of cost/efficiency reasons which are familiar to every manager. In the manufacture of semiconductor devices, the manufacturing equipment has, in the past, been so complex and inflexible that automation has been difficult to achieve. More particularly, such equipment has been designed without branching or redundant capabilities, so that the entire production process is affected if one link in the process chain breaks. Also, there is no capability in such prior processing equipment to add, subtract or change processing functions simply and easily. Thus, the prior processing equipment used in the semiconductor manufacturing industry has been custom built for each particular process, which would normally include a series of sequenced processing steps. If the process is modified by, for instance, eliminating one step, an entirely new piece of equipment may be necessary in order to accommodate such a modification. In such a situation, the original piece of equipment could be obsolete, while the new piece of equipment could require large amounts of time and money to manufacture, thereby resulting in an extremely costly and time-consuming replacement procedure for the user.

The present invention overcomes many of the problems and disadvantages of the prior art processing machines described above by providing a modular processing apparatus which includes a chassis and a number of individual modules, each of which is adapted to be plugged into the chassis. The modules are easily installed in the chassis with a minimum of tools. Thus, in addition to a complete range of initial configurations, the user can quickly redefine processing functions by simply substituting alternate modules. Also, replacement modules can be inserted for a defective module, thereby enabling the apparatus to continue operation while the defective module is being repaired. As a result of such design features, the apparatus not only meets the user's present needs, but also provides a uniquely flexible base for future expansion and change.

The apparatus is specifically designed to perform several process functions on a single track. Thus, each track can perform multiple process functions, such as scrub/bake/coat/bake. By keeping the silicon wafer stationary for the majority of the process functions, both wafer movement and machine size are minimized. A full range of dispense procedures, including static, dynamic, oscillating and radial, are possible without any hardware changes. All processing equipment is kept clear of the process area when not in use. Microwave and hotplate heating systems can be installed on the same track for dehydration, soft bake and hard bake functions.

While the apparatus of the present invention is an effective stand-alone unit, it is specifically designed to be used as a "building block". Simple reconfiguration enables the user to combine several tracks into a complete processing system: an interactive network operating without external assistance. Intrinsic to this "building block" concept is the ability for each apparatus to interface mechanically and electronically with other tracks in the system and to outside equipment, such as aligners, robots and inspection stations. Thus, an individual track can be interfaced with another track at any time to provide a combination of processes previously impossible to achieve without constructing a completely new machine.

According to the present invention, there is provided an apparatus for processing semicondutor devices, including a chassis, and attaching means for selectively and removably attaching independent modules to the chassis, each module performing at least one function on a workpiece to be processed, whereby the apparatus can be configured to perform many different process operations by adding and/or substracting the modules to the chassis.

In order that the invention may be more fully understood, it will now be described with reference to the accompanying drawings, in which:

Figure 1 is a perspective view of a basic apparatus or track provided with a microwave bake module and a coat module as optional equipment;

Figure 2 is an exploded view of a chassis assembly for the basic apparatus or track illustrated in Figure 1;

Figure 3 is an exploded view of an I-beam subassembly employed in connection with the chassis assembly shown in Figure 2;

Figure 4 is an exploded view of an elevator module frame subassembly employed by the basic apparatus or track illustrated in Figure 1;

Figure 5 is an exploded view of a locator plate subassembly employed in connection with the elevator module frame subassembly shown in Figure 4;

Figure 6 is an exploded view of a stop pin subassembly employed in connection with the elevator module frame subassembly shown in Figure 4;

Figure 7 is an exploded view of a load module employed by the basic apparatus or track illustrated in Figure 1;

Figure 8 is a perspective view of a transfer module adapted for use in connection with the basic apparatus or track illustrated in Figure 1; and

Figures 9-11 are schematic illustrations showing various configurations of the basic apparatus or track illustrated in Figure 1.

Although the present invention is suitable for use in connection with many different types of processing operations, it is especially suited for use in connection with the production of semiconductor devices from silicon wafers. Accordingly, the present invention will be described in connection with the production of such semiconductor devices.

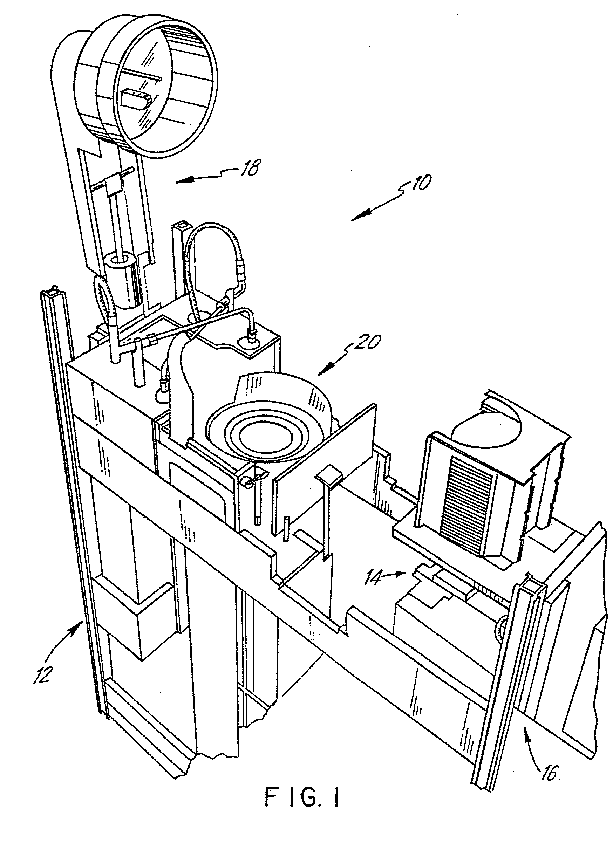

Referring to Figure 1, there is shown a basic wafer processing apparatus or track 10. The basic apparatus 10 includes, as standard equipment, a chassis 12, an elevator module 14 and a load module 16. A microwave bake module 18 and a coat module 20 are provided as optional equipment. Detailed descriptions of the chassis 12, the elevator module 14 and the load module 16 are set forth below, followed by a brief description of the microwave bake module 18, the coat module 20 and various other modules and accessories for the apparatus 10.

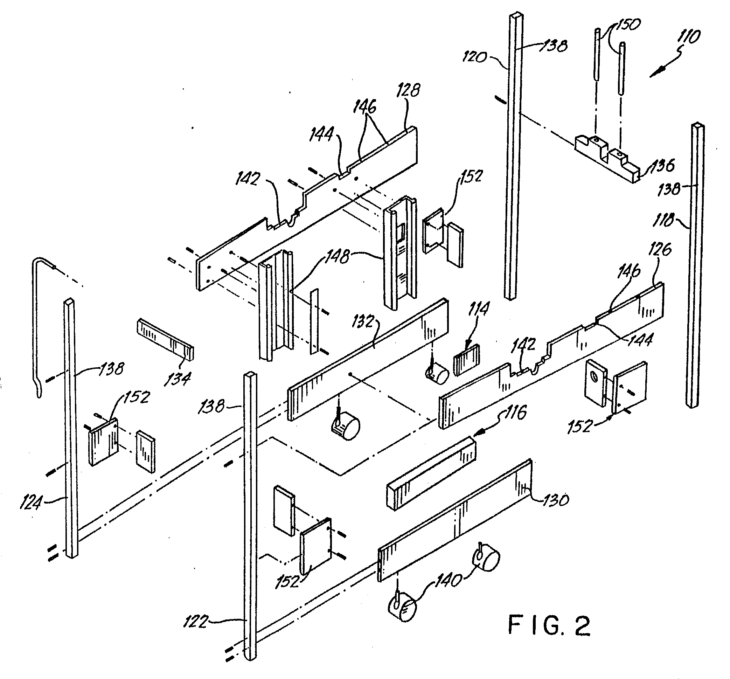

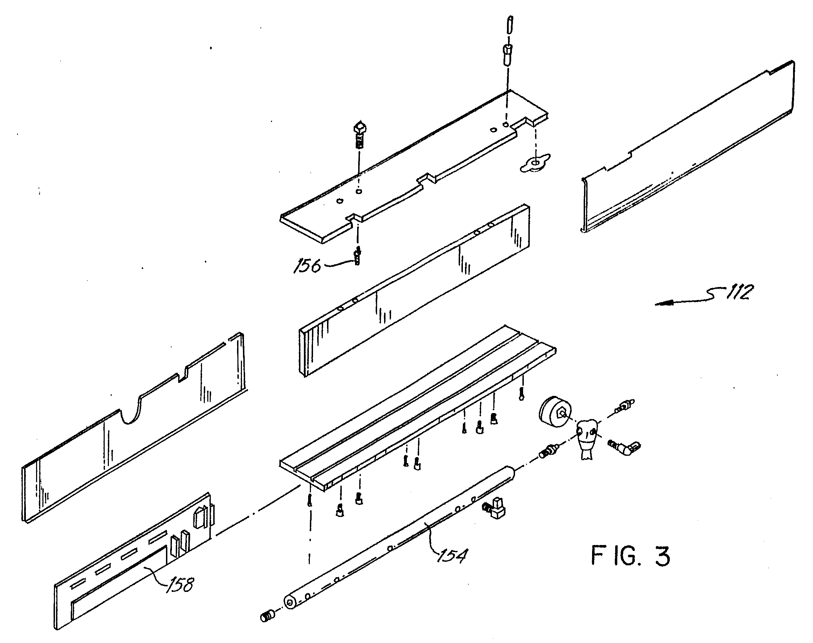

With reference to Figures 2 and 3, the chassis 12 is divided into four subassemblies. These subassemblies are a stringer subassembly 110, an I-beam subassembly 112, a sump subassembly 114 and an exhaust plenum subassembly 116.

Referring to Figure 2, the stringer subassembly 110, which is the main framework of the apparatus 10, includes four corner columns 118, 120 122, 124; upper side stringers 126, 128; lower side stringers 130, 132; and front and back stringers 134, 136, respectively. The corner columns 118, 120, 122, 124 are designed such that they not only screw into the stringers 126, 128, 130, 132, 134, 136, but align them as well. After the chassis 12 is assembled, trim strips (not shown) are slid down dovetail grooves 138 in the corner columns 118, 120, 122, 124 in order to give the chassis 12 an aesthetically pleasing appearance. Each of the stringers 126, 128, 130, 132, 134, 136 not only forms a part of the chassis 12, but also supports other various modules or additional subassemblies.

The lower stringers 130, 132 have casters 140 for transportation of the chassis 12. Locking feet (not shown) are also attached to the lower stringers 130, 132. The sump subassembly 114 is attached to the lower stringer 132, while the exhaust plenum subassembly 116 is attached to the lower stringer 130.

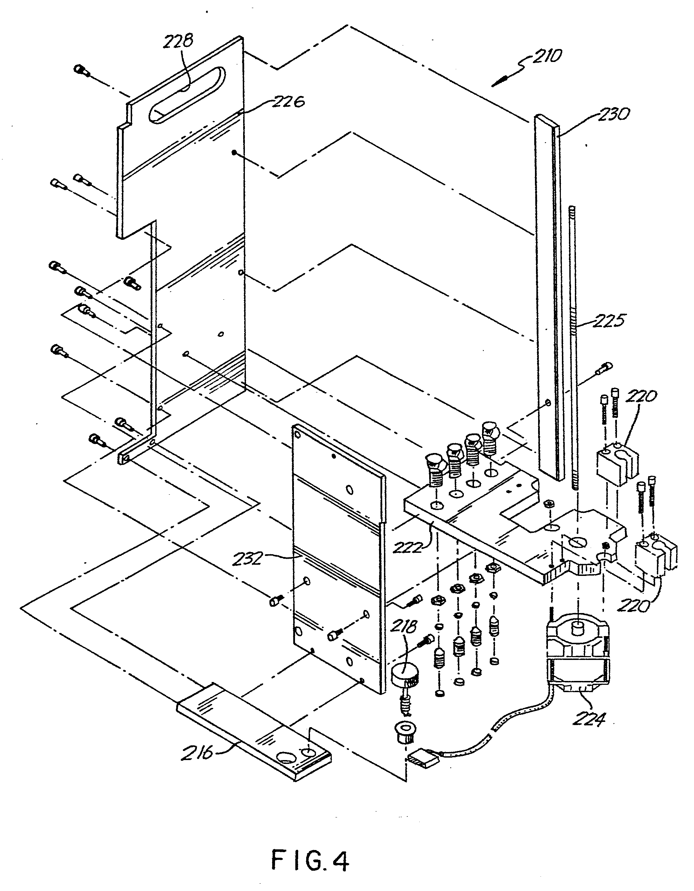

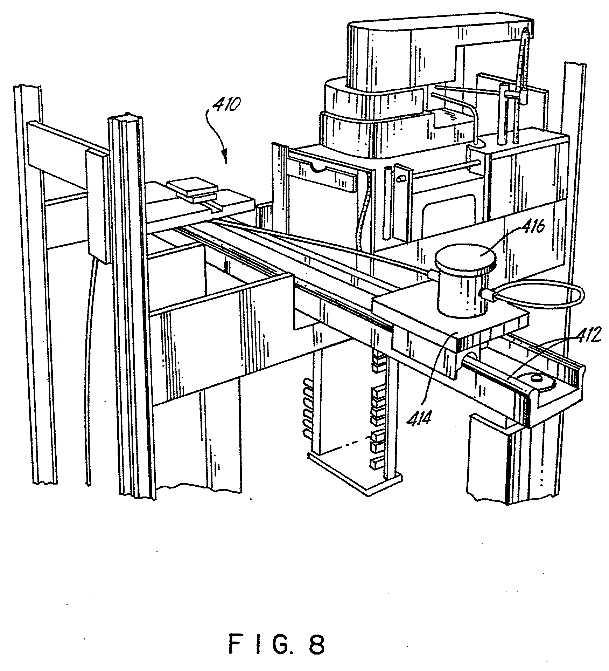

The upper stringers 126, 128 serve many purposes. A large cutout 142 in each of the upper stringers 126, 128 is either for a hotplate module (not shown) or a transfer module (see Figure 8). A smaller cutout 144 is provided in each of the upper stringers 126, 128 to provide access to a chuck motor (not shown) for alignment purposes. Holes 146 in the top of the upper stringers 126, 128 are for pinning certain modules in place, such as the chuck module (not shown). Hanging down from the upper stringer 128 are two twin rails 148 which provide guidance for the elevator module (see Figures 4-6) and the chuck module (not shown). The rails 148 are pinned to the upper stringer 128 to assure that the moving parts of each module ride up and down perpendicular to the upper stringers 126, 128 and the lower stringers 130, 132.

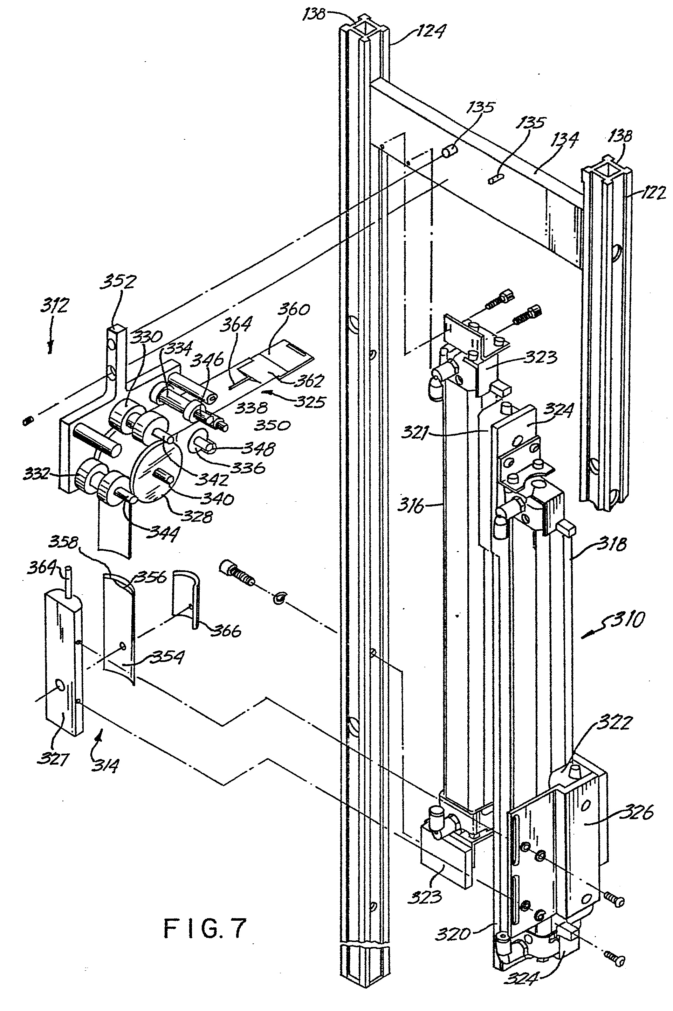

The front stringer 134 supports a load module (see Figure 7). The back stringer 136 has two rods 150 extending upwardly therefrom so as to slidably receive a bake module (not shown), such as the microwave bake module 18 (see Figure 1).

The corner columns 118, 120, 122, 124 carry brackets 152. These brackets 152 are provided to mount the I-beam subassembly 112 from the stringer subassembly 110.

Referring to Figure 3, the I-beam subassembly 112 is hung through the middle of the chassis 12 at a height designed to permit all modules to rest thereon. More particularly, the I-beam subassembly 112 includes a manifold 154 which runs air up through different ports (not shown) in the I-beam subassembly 112 for the purpose of supplying air to the various modules, each of which has its own air inlet so as not to interfere with other modules. Barb fittings 156 extend upwardly from the top of the I-beam subassembly 112. The barb fittings 156 connect to tubing (not shown) which extends to a vacuum supply. The tubing and the barb fittings 156 cooperate to supply vacuum to the hot plate module, the chuck module and the load module. The I-beam subassembly 112 also carries a backbone board 158 for all electronic signals. Each of the individual modules has a ribbon cable (not shown) which connects to the backbone board 158 so as to receive signals and power from a controller (not shown). The signals and power are supplied to the backbone board 158 through a cable subassembly (not shown).

Referring again to Figure 2, the sump subassembly 114 is provided to catch all residual processed liquids that are spun off of the wafer during processing. Exhaust is drawn directly through a drain tube (not shown) to suck in all liquids and assure that there is no clogging in the drain tube. The liquid and exhaust are then separated when they reach a drawer (not shown) in the sump subassembly 114.

Referring still to Figure 2, the exhaust plenum subassembly 116 is connected to house exhaust. The exhaust plenum subassembly 116 creates a downward laminar flow of clean air through the chassis 12 in order to remove defect-generating particles from the process area of the apparatus 10.

With reference to Figures 4-6, the elevator module 14 includes three basic subassemblies. These subassemblies are a frame subassembly 210, a locator plate subassembly 212 and a stop pin subassembly 214.

Referring to Figure 4, the frame subassembly 210 includes a base 216 which is provided with a quarter turn fastener 218 adapted to lock the elevator module 14 in place on the chassis 12. Two bearings 220 are provided on a motor plate 222 for the purpose of guiding the elevator module 14 in place as it is applied to the chassis 12. The motor plate 222 also supports a motor 224, which drives a non-rotating lead screw 225 up and down. The frame subassembly 210 also includes a handle plate 226 which is provided with a cutout 228 so that a user can grab the handle plate 226 in order to remove or replace the elevator module 14. Attached to the handle plate 226 is a switch plate 230, which holds various sensors (not shown). A valve plate 232 is also provided on the frame subassembly 210. The valve plate 232 carries a valve subassembly (not shown).

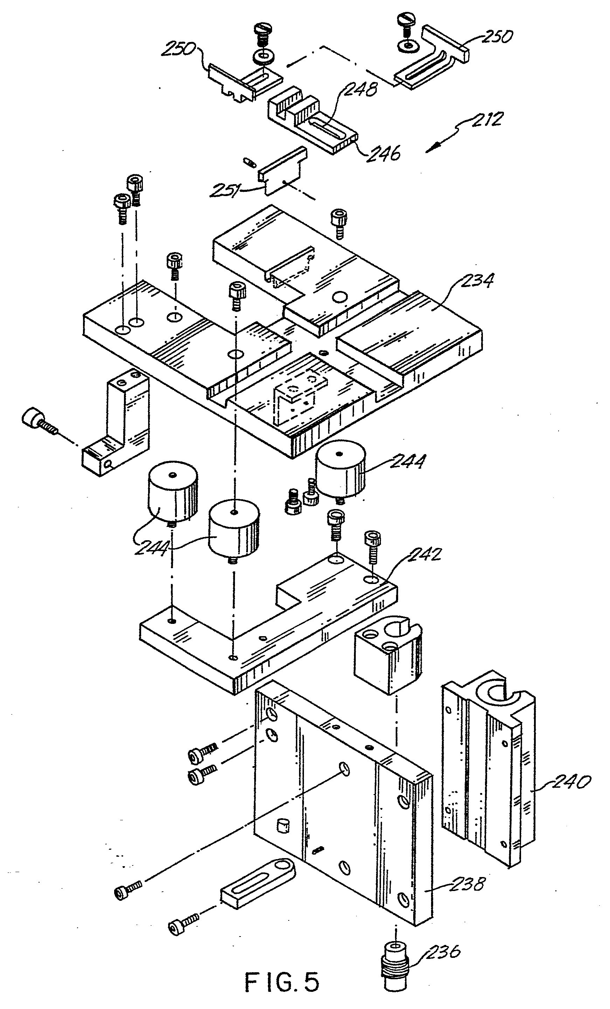

With reference now to Figure 5, the locator plate subassembly 212 includes a locator plate 234 which is driven up and down by the lead screw 225. The lead screw 225 is connected to a bellows 236 which, in turn, is connected to a bearing plate 238. The bellows 236 absorbs any vibration that might pass through the lead screw 225 as it raises and lowers the locator plate 234. The bearing plate 238 has a bearing 240 attached to it for the purpose of guiding the locator plate 234 as it moves up and down on the twin rails 148 of the chassis 12 (see Figure 2). The bearing 240 is in alignment with the bearings 220 on the frame subassembly 210. A shock mount plate 242 is also connected to the bearing plate 238. There are three shock mounts 244 screwed into the shock mount plate 242 in order to absorb any vibration that may have avoided the bellows 236. The shock mount plate 242 also supports the locator plate 234.

A locator 246 is provided in the center of the locator plate 234. The locator 246 is adjustable for different cassettes. A slot 248 in the locator 246 receives a bar (not shown) of any suitable wafer cassette. Slide retainers 250 are adjustable so as to accommodate any size cassette. The slide retainers 250 are positioned so as to locate the cassette in the center of the locator plate 234. When a cassette is placed on the locator plate 234, an actuator 251 is depressed so as to actuate a sensor (not shown), which signals the controller that a cassette has been loaded onto the locator plate 234.

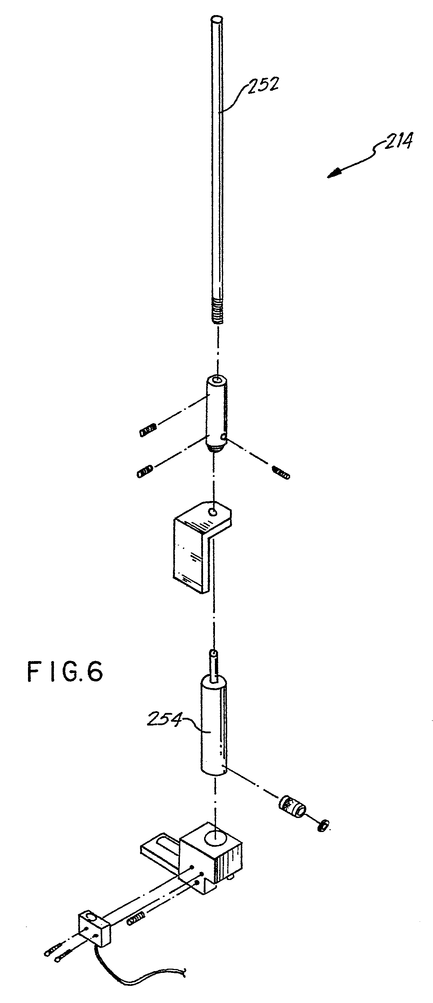

Referring now to Figure 6, the stop pin subassembly 216 includes a stop pin 252 and a cylinder 254 adapted to extend and retract the stop pin 252. The stop pin 252 is actually a safety guard for the wafer, which is normally left off in the cassette before the stop pin 252. In order to guard against the possibility that the wafer may continue to slide back as it is delivered to the cassette, the stop pin 252 is raised to limit the backward movement of the wafer upon its return to the cassette.

Because the lead screw 225 does not rotate as it raises and lowers the locator plate 234, particle generation is substantially limited to inside the motor 224, thereby minimizing particle generation in the vicinity of the wafers. The location of the motor 224 and all other moving parts below the cassette also contributes to minimizing particle generation in the vicinity of the wafers.

With reference to Figure 7, the load module 16 includes three basic subassemblies. These subassemblies are a cylinder subassembly 310, a roller subassembly 312 and a load arm subassembly 314.

The cylinder subassembly 310 includes one fixed band cylinder 316 and one movable band cylinder 318. The fixed cylinder 316 is attached to the corner column 124 and the stringer 134 of the chassis 12. The movable cylinder 318 is attached to a plate 320, which is screwed to a piston 321 of the fixed cylinder 316. The movable cylinder 318 has a piston 322.

Combined movement of both of the cylinders 316, 318 will move a wafer from a cassette to the chuck module (not shown). More particularly, the movable cylinder 318 is adapted to move the wafer from the cassette to the hotplate module (not shown). The fixed cylinder 316 is adapted to transport the wafer from the hotplate module to the chuck module (not shown).

There are brackets 323, 324 at the ends of the cylinders 316, 318, respectively. The brackets 323, 324 mount sensors (not shown). Another sensor (not shown) is mounted on a bracket attached to the plate 320 which holds the movable cylinder 318. When this sensor is activated, vacuum on a load arm 325 of the load arm subassembly 314 is shut off so that the wafer which is being transported by the load arm 325 is left off in the cassette just before the stop pin 252 of the elevator module 14 (see Figure 6).

The cylinder subassembly 310 also includes a standoff 326 and an adapter slide 327. The standoff 326 is attached to the piston 322 of the movable cylinder 318, while the adapter slide 327 is attached to the standoff 326. The adapter slide 327 is adjustable up and down for different size wafers.

The roller subassembly 312 includes rollers 328, 330, 332, 334, 336, 338. Each of the rollers 328, 330, 332, 334, 336, 338 has its own shaft 340, 342, 344, 346, 348, 350, respectively. There are two roller plates 352 (only one of which is shown) cooperating to sandwich the rollers 328, 330, 332, 334, 336, 338 therebetween. Each of the roller plates 352 has bearings (not shown) to receive the shafts 340, 342, 344, 346, 348, 350. Snap rings (not shown) are inserted on the ends of the shafts 340, 342, 344, 346, 348, 350 in order to hold them in place. So as to hold the roller subassembly 312 rigid and square, three standoffs (not shown) are provided between the corners of the roller plates 352. The flanged roller 328 is surrounded by the floating rollers 330, 332. The floating rollers 330, 332 support and guide the flexible load arm 325 of the load arm subassembly 314 at the bending point of the load arm 325. The rollers 334, 336 are the guide and level rollers. The guide roller 334 is adapted to hold the load arm 325 straight and to urge it down onto the level roller 336. The roller 338 gives the load arm 325 extra support when it is fully extended. The roller subassembly 312 is aligned by pins 135 and screwed to the front stringer 134.

The load arm 325 of the load arm subassembly 314 includes three pieces of hardened steel 354, 356, 358 and a head 360. The three pieces of steel 354, 356, 358 are laid one on top of the other. A fitting 362 is positioned at the end of a load arm 325 so as to receive vacuum tubing 364. The load arm 325 is fed between the rollers 328, 330, 332, 334, 336, 338 and down to the adapter slide 327, where a clamp 366 attaches the load arm 325 to the adapter slide 327. The load arm 325 slides back and forth through the rollers 328, 330, 332, 334, 336, 338 as the pistons 321, 322 of the cylinders 316, 318 move up and down. The vaccum tubing 364 is attached to the vacuum supply for the elevator module 14 through the adaptor slide 327.

In addition to the microwave bake module 18 and the coat module 20, various other optional modules may be used on the apparatus 10. These modules include the chuck module, which performs various processing functions on the wafers, a hotplate bake module, a scrub module, a negative develop module, a positive develop module, a vapor prime module (see applicant's European patent application filed concurrently herewith entitled "PROCESSING APPARATUS AND METHOD") and a transfer module.

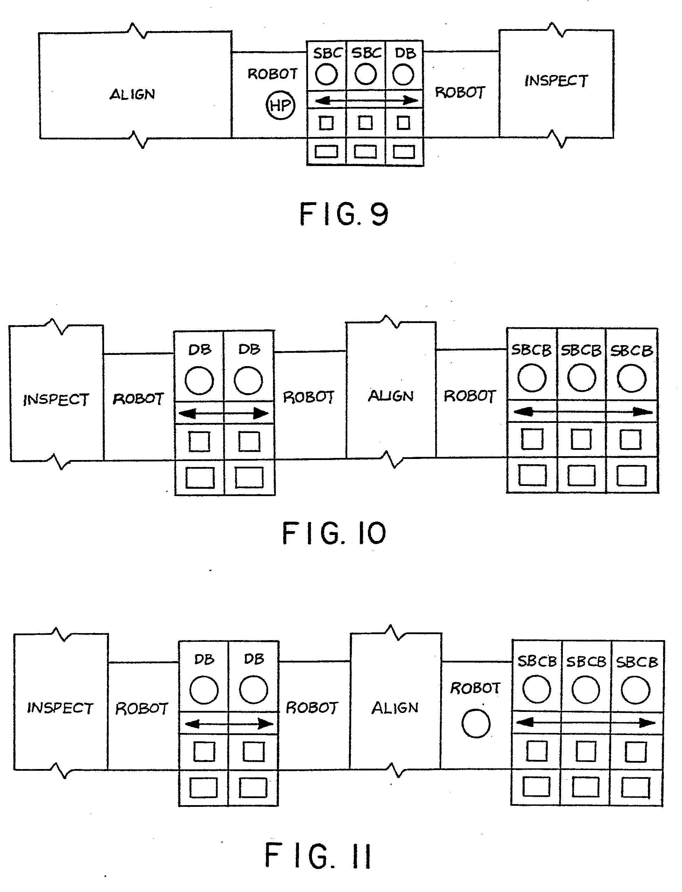

With reference to Figure 9, a transfer module 410 is shown. The transfer module 410 includes tracks 412 which extend laterally from the apparatus 10. A carriage 414 is mounted for sliding movement along the tracks 412. A chuck 416 is carried by the carriage 414. The chuck 416 is adapted to transport a wafer from the apparatus 10 to another apparatus interfaced therewith. Thus, the track module 410 permits the apparatus 10 to be combined with other similar apparatus and with accessory equipment, such as robots, aligners and inspection stations, in many different configurations (see, for instance, Figures 9-11).

It will be understood that the embodiments described herein are merely exemplary and that a person skilled in the art may make many variations and modifications without departing from the spirit and scope of the invention. All such modifications and variations are intended to be included within the scope of the invention as defined in the appended claims.

CLAIMS:

1. Apparatus for processing semiconductor devices, including a chassis, characterized by attaching means (135, 142, 146, 150) for selectively and removably attaching independent modules (14, 16, 18, 20) to said chassis (12), each module performing at least one function on a workpiece to be processed, whereby said apparatus can be configured to perform many different process operations by adding and/or subtracting said modules to said chassis.

2. The modular processing apparatus of Claim 1, further characterized by a load module (16) which includes a flexible load arm (325), means (312) for bending said load arm, means (310) for extending and retracting said load arm and means (364) for supplying a vacuum to said load arm so as to maintain a workpiece thereon during the extension and retraction of said load arm.

3. The modular processing apparatus of Claim 1 or 2, further characterized by an elevator module (14) which includes supporting means (234) for supporting a cassette of workpieces on said supporting means and moving means (224, 225) for moving said supporting means up and down, said moving means including a non-rotating lead screw (225) located below said supporting means.

4. The modular processing apparatus of Claim 1, 2 or 3, further characterized by means (116) for forming a downward laminar flow of air through said chassis, whereby dirt and foreign substances are maintained out of the vicinity of a processing area defined by one or more of said modules.

5. The modular processing apparatus of any one of the preceding Claims, characterized in that said chassis includes a plurality of corner columns (118, 120, 122, 124); a plurality of lower stringers (130, 132), each lower stringer being connected between two adjacent corner columns; and a plurality of upper stringers (126, 128, 134, 136), each upper stringer being connected between two adjacent corner columns.

6. The modular processing apparatus of any one of the preceding Claims, characterized in that said chassis includes casters (140).

7. The modular processing apparatus cf any one of the preceding Claims, characterized in that said chassis includes a sump (114).

8. The modular processing apparatus of any one of the preceding Claims, characterized in that said chassis includes an exhaust plenum (116).

9. The modular processing apparatus of Claim 5, characterized in that at least one of said upper stringers is provided with a cutout (142) sized and shaped so as to receive one of said modules.

10. The modular processing apparatus of Claim 5, characterized in that at least one of said upper stringers is provided with holes (146) sized and shaped so as to receive pins provided on one of said modules.

11. The modular processing apparatus of Claim 5, characterized in that at least one of said upper stringers is provided with a pair of rails (148), said rails depending from said at least one upper stringer so as to ensure that a movable portion of one of said modules is guided in a direction which is generally perpendicular to said at least one upper stringer.

12. The modular processing apparatus of any one of the preceding Claims, characterized in that said chassis includes means (112) for supplying air to one or more of said modules.

13. The modular processing apparatus of Claim 5, characterized in that said corner columns include dovetail grooves (138) sized and shaped so as to receive trim strips.

14. The modular processing apparatus of any one of the preceding Claims, characterized in that one of said modules is a transfer module (410) which extends from said processing apparatus to another processing apparatus.

15. The modular processing apparatus of Claim 14, characterized in that said transfer module includes tracks (412), a carriage (414) movably mounted on said tracks and a chuck (416) carried by said carriage so as to transport a workpiece from said processing apparatus to said another processing apparatus.

16. The modular processing apparatus of any one of the preceding Claims, characterized in that said modules include a microwave bake module (18) and a coat module (20).

0162703

FIG. I

FIG. 2

FIG. 3

0162703

0162703

FIG.4

FIG.5

FIG.6

FIG. 7

0162703

FIG. 8

FIG. 9

FIG. 10

FIG. 11